# EUROPEAN PATENT APPLICATION

(11) **EP 3 913 938 A1**
(43) Date of publication of application: **24.11.2021**
(21) Application number: 20741733.8
(22) Date of filing: 10.01.2020
(51) Int. Cl.: H04W 4/38

(54) **USER EQUIPMENT IN WIRELESS COMMUNICATION SYSTEM**

(30) Priority: 16.01.2019 CN 201910040017
(71) Applicant: Sony Group Corporation, 108-0075 Tokyo (JP)
(72) Inventor: GUO, Xin, Beijing 100028 (CN); SUN, Chen, Beijing 100028 (CN); SHEN, Hong, Nanjing, Jiangsu 211111 (CN)
(74) Representative: D Young & Co LLP
(86) International application number: PCT/CN2020/071269
(87) International publication number: WO 2020/147650

(57) **Abstract**

The present disclosure relates to a user equipment in a wireless communication system. The user equipment according to the present disclosure comprises a processing circuit and is configured to: send first data by using a first transmission power during a first time period; and send differential data of the first data by using a second transmission power during a second time period, the differential data being the difference between the first data and second data that is expected to be sent during the second time period.

## Description

This application claims the priority to Chinese Patent Application No. 201910040017.2 titled "USER EQUIPMENT IN WIRELESS COMMUNICATION SYSTEM", filed on January 16, 2019 with the China National Intellectual Property Administration, which is incorporated herein by reference in its entirety.

### FIELD

The present disclosure relates to the technical field of wireless communications, and in particular to user equipment in a wireless communication system, an electronic device in a wireless communication system, a wireless communication method performed by user equipment, a wireless communication method performed by an electronic device, and a computer-readable storage medium.

### BACKGROUND

Internet of Things (IoT) is an information carrier such as the Internet and conventional telecommunications network, and is a network which enables all ordinary objects that can operate independently to interconnect and intercommunicate with each other. The Internet of Things is generally a wireless network. Since there are 1,000 to 5,000 devices around each person, the Internet of Things may include 500 to 1000 trillion objects. On the Internet of Things, everyone may use an electronic tag such as a radio frequency tag to connect real objects to the network. Specific locations of the objects can be found in the Internet of Things. Through the Internet of Things, a computer can manage and control machines, devices and personnel in a centralized way, and can also remotely control home devices and cars, as well as searching locations and preventing articles from being stolen, similar as an automatic control system. In addition, big data may be generated by collecting data on the above trivial things. The big data may bring significant changes to society, such as redesigning roads to reduce traffic accidents, urban renewal, disaster prediction, prevention and control of crime, and epidemic control, thereby achieving connection of objects. The Internet of Things digitizes the real world and has a wide range of applications. The Internet of Things gathers scattered information and integrates digital information on the objects. The Internet of Things has broad application prospects, and is mainly applied in fields of transportation and logistics, industrial manufacturing, health care, intelligent environment (such as home, office, and factory), personal use, society and the like.

In the future wireless communication system, requirements for communication delay of Internet of Things are increasing. Especially in scenarios sensitive to delay such as the industrial Internet of Things, a communication delay is required to be at the microsecond level. Currently, 5G system requires that an end-to-end communication delay is at the milliseconds level, which however cannot meet the requirement of some high-performance industrial Internet of Things application. Therefore, it is required to improve the existing low-delay communication technology, to further reduce the delay and ensure the transmission reliability.

User equipment, an electronic device, a wireless communication method performed by user equipment, a wireless communication method performed by an electronic device, and a computer-readable storage medium are provided according to the present disclosure, which can achieve communication with low delay and high reliability.

### SUMMARY

This part provides a general summary of the present disclosure, rather than a comprehensive disclosure of full scope or all features of the present disclosure.

User equipment in a wireless communication system is provided according to the present disclosure. The user equipment includes processing circuitry. The processing circuitry is configured to transmit first data with first transmission power within a first period of time, and transmit differential data of the first data with second transmission power within a second period of time, wherein the differential data is a difference between second data expected to be transmitted within the second period of time and the first data.

An electronic device is provided according to another aspect of the present disclosure. The electronic device includes processing circuitry. The processing circuitry is configured to: receive first data as initial data within a first period of time, calculate first control command data based on the first data, and transmit the first control command data; receive differential data of the first data within a second period of time, wherein the differential data is a difference between initial data expected to be received within the second period of time and the first data; add the differential data and the first data to recover second data, calculate second control command data based on the second data, and transmit the second control command data.

A wireless communication method performed by user equipment is provided according to another aspect of the present disclosure. The wireless communication method includes: transmitting first data with first transmission power within a first period of time, and transmitting differential data of the first data with second transmission power within a second period of time, wherein the differential data is a difference between second data expected to be transmitted within the second period of time and the first data.

A wireless communication method performed by an electronic device is provided according to another aspect of the present disclosure. The wireless communication method includes: receiving first data as initial data within a first period of time, calculating first control command data based on the first data, and transmitting the first control command data; receiving differential data of the first data within a second period of time, wherein the differential data is a difference between initial data expected to be received within the second period of time and the first data; adding the differential data and the first data to recover second data, calculating second control command data based on the second data, and transmitting the second control command data.

A computer-readable storage medium is provided according to another aspect of the present disclosure. The computer-readable storage medium includes executable computer instructions that, when being executed by a computer, cause the computer to implement the method according to the present disclosure.

With the user equipment, the electronic device, the wireless communication method performed by user equipment, the wireless communication method performed by an electronic device, and the computer-readable storage medium according to the present disclosure, communication with low delay and high reliability can be achieved.

Further scope of applicability may become apparent from the description provided herein. The description and specific examples in the summary are for illustrative purposes only, rather than intended to limit the scope of the present disclosure.

### BRIEF DESCRIPTION OF THE DRAWINGS

Drawings described herein show only illustrative embodiments rather than all embodiments, and are not intended to limit the scope of the present disclosure. In the drawing:
Figure 1 is a schematic diagram showing an application scenario of an example according to an embodiment of the present disclosure;
Figure 2 is a flow chart showing data differentiation performed at an application layer according to an embodiment;
Figure 3 is a flow chart showing data differentiation performed at an application layer according to another embodiment;
Figure 4 is a flow chart showing data differentiation performed at a medium access control layer according to an embodiment;
Figure 5 is a flow chart showing data differentiation performed at a medium access control layer according to another embodiment;
Figure 6 is a flow chart showing data differentiation performed at a physical layer according to an embodiment;
Figure 7 is a flow chart showing data differentiation performed at a physical layer according to another embodiment;
Figure 8 is a flow chart showing adaptive power control according to an embodiment of the present disclosure;
Figure 9 is a structural block diagram of user equipment 900 according to an embodiment of the present disclosure;
Figure 10 is a structural block diagram of an electronic device 1000 according to an embodiment of the present disclosure;
Figure 11 is a flow chart showing a wireless communication method performed by the user equipment 900 according to an embodiment of the present disclosure;
Figure 12 is a flow chart showing a wireless communication method performed by the electronic device 1000 according to an embodiment of the present disclosure;
Figure 13 is a schematic diagram showing a data flow between layers of a 5G protocol stack according to an embodiment of the present disclosure;
Figure 14 is a block diagram showing a first configuration example of an eNB (evolution Node Base Station ) or a gNB (that is, a base station in a fifth generation communication system) to which the present disclosure is applied;
Figure 15 is a block diagram showing a second configuration example of an eNB or a gNB to which the present disclosure is applied;
Figure 16 is a block diagram showing a configuration example of a smart phone to which the present disclosure is applied; and
Figure 17 is a block diagram showing a configuration example of a vehicle navigation device to which the present disclosure is applied.

Although the present disclosure is susceptible to various modifications and alternative forms, specific embodiments thereof are shown as examples in the drawings and are described in detail herein. It should be understood that the description for the specific embodiments herein is not intended to limit the present disclosure to the disclosed specific forms. Instead, the present disclosure is intended to encompass all modifications, equivalents and alternatives that fall within the spirit and scope of the present disclosure. It should be noted that, reference numerals indicate components corresponding to the reference numerals throughout the drawings.

### DETAILED DESCRIPTION OF EMBODIMENTS

Examples of the present disclosure are described more fully with reference to the drawings. The following description is merely illustrative rather than intended to limit the present disclosure and applications or uses of the present disclosure.

Illustrative embodiments are provided so that the present disclosure is exhaustive and fully conveys the scope of the present disclosure to those skilled in the art. Various specific details such as specific components, devices and methods are set forth to provide thorough understanding for the embodiments of the present disclosure. It is apparent to those skilled in the art that the illustrative embodiments may be implemented in many different forms without the specific details, and none of them should be interpreted as a limit for the scope of the present disclosure. In some illustrative embodiments, well-known processes, well-known structures and well-known technologies are not described in detail.

UE (that is, User Equipment) in the present disclosure includes but is not limited to a sensor device, a device with a sensor device (such as mobile terminal, computer or onboard device), and a device without a sensor device (such as mobile terminal, computer or onboard device). All of these devices have a wireless communication function. Alternatively, depending on specific function as described, the UE in the present disclosure may be the UE itself or a component (such as chip) in the UE. Similarly, a base station in the present disclosure may be, for example, an eNB (evolution Node Base Station), a gNB (next Generation Node Base Station, that is, a base station in a fifth generation communication system) or a component such as a chip in the eNB or the gNB. A tag in the present disclosure may be a tag used for communication in any communication environment. The environment includes but is not limited to, for example, the fourth generation communication system environment, the fifth generation communication system environment, and Wi-Fi communication environment. An uplink communication mode and a downlink communication mode of devices in the present disclosure may be the same or different.

The conventional solutions to communication with low delay focus on how to reduce a length of a single timeslot. The timeslot described herein is for example a mini-slot introduced to the 5G system. Compared with the conventional transmission solutions based on sub-frame, these solutions of reducing the length of the timeslot can significantly reduce system delay. A method for designing a shortest timeslot for an orthogonal frequency division multiplexing (OFDM) system is proposed in a paper titled "Physical Layer Design of High-Performance Wireless Transmission for Critical Control Applications" and published by M. Luvisotto et al in IEEE Transactions on Industrial Informatics, Vol. 13, No. 6, pp. 2844-2854, on December 2017. In addition, a preamble solution requiring only a single OFDM symbol is proposed in the paper.

A reduction in the length of the single timeslot can reduce the system delay. However, the system delay is further related to a length of transmitted data, that is, the number of timeslots occupied by the data. In addition, the above literature only considers reducing the number of timeslots occupied by the preamble, but does not study how to reduce a length of a payload of the data. Therefore, there is still room for further reducing the delay.

In order to better explain the technical solutions of the present disclosure to facilitate the understanding, an application scenario of industrial Internet of Things is described as an example. It should be noted that, the application scenario of the industrial Internet of Things is for illustrative purposes only, rather than intended to limit the present disclosure. Those skilled in the art can understand that the technical solutions of the present disclosure are applicable to other application scenarios.

Compared with the conventional technology, the present disclosure has the following 5 advantages.
1. The length of the transmitted data is reduced by transmitting differential data, thereby effectively reducing the delay.
2. Adaptive power control is introduced to ensure transmission reliability of the system.
3. A parameter N (which is described below) is adjustable according to specific scenarios, thereby having good scalability.
4. Only one indicator bit is additionally introduced into the preamble, and therefore the resulting overhead and impact on the delay may be ignored.
5. The change to the conventional communication solution of the industrial Internet of Things is small, and thus implementation complexity is low.

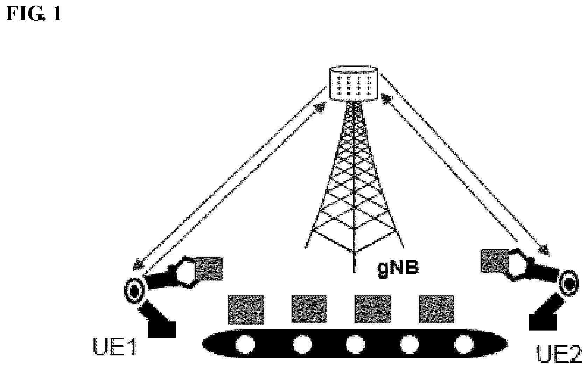

Figure 1 is a schematic diagram showing an application scenario of an example according to an embodiment of the present disclosure for illustrative purposes only.

As shown in Figure 1, user equipment 1 (i.e., UE1 as shown in Figure 1) and user equipment 2 (i.e., UE2 as shown in Figure 1) control transfer of objects on a conveyor belt. One of the UE1 and the UE2 transfers the objects, and the other receives the objects. The UE herein includes but is not limited to a sensor device, and a device with a sensor device (such as mobile terminal, computer or onboard device). All of these devices have a wireless communication function. Alternatively, depending on the specific function described, the UE may be the UE itself or a component (such as chip) in the UE.

The UE1 and the UE2 are capable of communicating with, for example, a gNB in Figure 1. It is required to briefly introduce the application scenarios of the industrial Internet of Things herein. The industrial Internet of Things includes a sensor node (for acquiring data in the industrial Internet of Things), a control node (for calculating a control command in the industrial Internet of Things) and an execution node (for executing the control command in the industrial Internet of Things). In the scenario shown in Figure 1, the UE1 and the UE2 may both serve as the sensor nodes and the execution nodes, and the gNB may serve as the control node. The present disclosure is not limited to the above. In a case that the UE1 and the UE2 only serve as the sensor nodes that provide sensing data and do not provide execution functions, another device may serve as the execution node.

In communication environment shown in Figure 1, for example, UE1/UE2 acquires sensing data and transmits the sensing data to the gNB. The gNB calculates a command for controlling execution performed by the execution node based on the sensing data received from the UE1/UE2, and then transmits the command to the UE1/UE2 or another execution device. In response to the command, the UE1/UE2 or another execution device transfers the objects as shown in Figure 1.

The control operation in the above described illustrative scenario of the industrial Internet of Things may be control of speed of the conveyor belt caused by, for example, discarding, shelving, adding and weight of objects on the conveyor belt. However, the above description is only illustrative. Since the scenarios of the industrial Internet of Things have a large number of application scenarios relying on data communication, the present disclosure is not limited to the application scenario shown in Figure 1. The example in Figure 1 is only to clearly explain various embodiments of the present disclosure based on this specific application scenario.

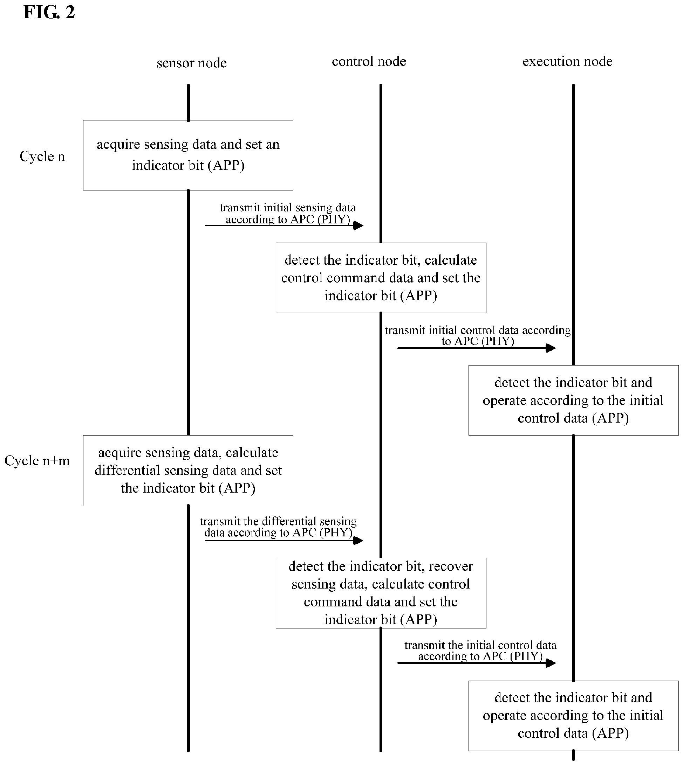

In order to solve problems of communication delay among various devices and communication reliability in the case of reduced delay in the application scenario shown in Figure 1 above, the differential data is transmitted in the industrial Internet of Things environment according to the present disclosure, to significantly reduce the system delay, and ensure the transmission reliability utilizing the adaptive power control. Next, a communication method with low delay according to embodiments of the present disclosure in the scenario of the industrial Internet of Things shown in Figure 1 is described with reference to Figures 2 to 7.

Figures 2 to 7 are flow charts showing communication among various nodes according to the embodiments of the present disclosure. It should be noted that a node described herein is not equivalent to a device. Different nodes may be located in a same device. The node represents an entity with a specific function so as to facilitate the understanding of the communication. In order to facilitate the understanding of the embodiments of the present disclosure, terms to be utilized below are described. An APP layer represents an application layer, which provides an interface for direct communication with an application and provides common network application services. A MAC layer represents a medium access control layer, which forms frames from the bitstream of the physical layer, performs error check based on error check information at the end of the frame, and further provides access to a shared-medium. A PHY layer represents a physical layer, which provides transmission medium and an interconnection device for data communication between devices, and provides a reliable environment for data transmission. APC represents adaptive power control. In the following description, the communication between nodes are described by taking the sensor node (for acquiring data in the industrial Internet of Things), the control node (for calculating the control command in the industrial Internet of Things) and the execution node (for executing the control command in the industrial Internet of Things) as communication objects. It should be noted that different nodes may correspond to the same device. For example, as described above, the sensor node and the execution node may both correspond to user equipment. Alternatively, different nodes may correspond to different devices, a correspondence between a node and a device is determined depending on specific application scenarios or application requirements. Lower power and higher power are relative concepts, and the higher power has a larger power value than the lower power.

Figure 2 is a flow chart showing data differentiation performed at an application layer according to an embodiment.

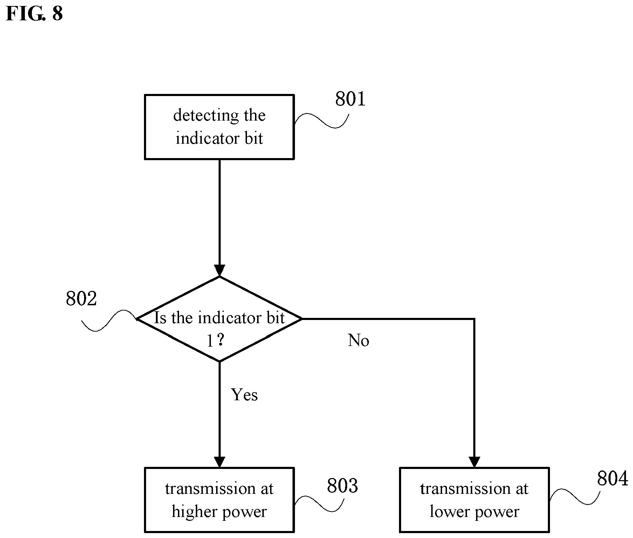

As shown in Figure 2, in an n-th cycle (n≥1) for transmitting initial data, an APP layer of the sensor node acquires the sensing data and sets differential indication information (that may be 1-bit data) corresponding to the sensing data to 0 (for example, the differential indication information of 0 indicates that to-be-transmitted data is the initial data acquired in the current cycle, and the differential indication information of 1 indicates that the to-be-transmitted data is differential data of the initial data acquired in the current cycle). According to the adaptive power control scheme shown in Figure 8, in a case that the APP layer of the sensor node detects that the differential indication information is 0 and further determines that power indication information (that may be 1-bit data, and may be set to 0 or 1 to distinguish two states) is 0 (for example, the power indication information of 0 indicates that data is transmitted at the lower power, and the power indication information of 1 indicates that data is transmitted at the higher power), or in a case that the APP layer of the sensor node only detects that the differential indication information is 0, when the differential indication information or the power indication information is determined to be 0, the PHY layer of the sensor node transmits, to the control node, initial sensing data and the differential indication information corresponding to the sensing data (as well as the power indication information as needed) at the lower power. The differential indication information is set in a header of a data packet of a corresponding layer to indicate whether the data packet is the initial data or the differential data. Here, instead of the power indication information, the differential indication information may be used to indicate both a type of the transmitted data and power used for transmitting the data. In this way, power information may be acquired based on the differential indication information if the power information is needed in subsequent communication. However, it is not redundant to set different indication information to respectively indicate the type of the transmitted data and the power used for transmitting the data, because in some application scenarios or application requirements, indication information may be set in different manners from the above examples, and setting different indication information may reduce data transmission in some application scenarios.

At the control node, an APP layer of the control node determines that the received differential indication information corresponding to the sensing data is equal to 0, and thereby determines that the received sensing data is the initial sensing data. Therefore, the APP layer of the control node calculates initial control command data based on the received initial sensing data, and sets the differential indication information corresponding to the control command data to 0. The PHY layer of the control node transmits the initial control command data at the lower power according to the adaptive power control scheme shown in Figure 8.

At the execution node, an APP layer of the execution node (that may be located at the same device as the sensor node) determines that the differential indication information corresponding to the control command data is 0, and thus determines that the received control command is an initial control command. Then the APP layer of the execution node performs operations according to the received initial control command data.

In an (n+m)-th cycle (1≤m≤N-1) for transmitting differential data, the APP layer of the sensor node acquires the sensing data, calculates a difference between sensing data acquired in the (n+m)-th cycle and the initial sensing data acquired in the n-th cycle to obtain differential sensing data, and sets the differential indication information corresponding to the sensing data to 1 (for example, the differential indication information of 0 indicates that the to-be-transmitted data is the initial data acquired in the current cycle, and the differential indication information of 1 indicates that the to-be-transmitted data is differential data of the initial data acquired in the current cycle). According to the adaptive power control scheme shown in Figure 8, in a case that the APP layer of the sensor node detects that the differential indication information is 1 and further determines that power indication information (that may be 1-bit data, and may be set to 0 or 1 to distinguish two states) is 1 (for example, the power indication information of 0 indicates that data is transmitted at the lower power, and the power indication information of 1 indicates that data is transmitted at the higher power), or in a case that the APP layer of the sensor node only detects that the differential indication information is 1, when the differential indication information or the power indication information is determined to be 1, the PHY layer of the sensor node transmits, to the control node, the initial sensing data and the differential indication information corresponding to the sensing data (as well as the power indication information as needed) at the higher power. The differential indication information is set in a header of a data packet of a corresponding layer to indicate whether the data packet is the initial data or the differential data. Here, instead of the power indication information, the differential indication information may be used to indicate both a type of the transmitted data and power used for transmitting the data. In this way, power information may be acquired based on the differential indication information if the power information is needed in subsequent communication. However, it is not redundant to set different indication information to respectively indicate the type of the transmitted data and the power used for transmitting the data, because in some application scenarios or application requirements, indication information may be set in different manners from the above examples, and setting different indication information may reduce data transmission in some application scenarios.

At the control node, the APP layer of the control node determines that the received differential indication information corresponding to the sensing data is equal to 1, and thereby determines that the received sensing data is the differential sensing data. Accordingly, it recovers the initial sensing data in the (n+m)-th cycle according to the received differential sensing data and the initial sensing data in the n-th cycle, calculates the initial control command data in the (n+m)-th cycle, and sets the differential indication information corresponding to the control command data to 0. The PHY layer of the control node transmits the initial control command data at the lower power according to the adaptive power control scheme shown in Figure 8.

At the execution node, the APP layer of the execution node (that may be located at the same device as the sensor node) determines that the differential indication information corresponding to the control command data is 0, and thus determines that the received control command is an initial control command. Then the APP layer of the execution node performs operations according to the received initial control command data.

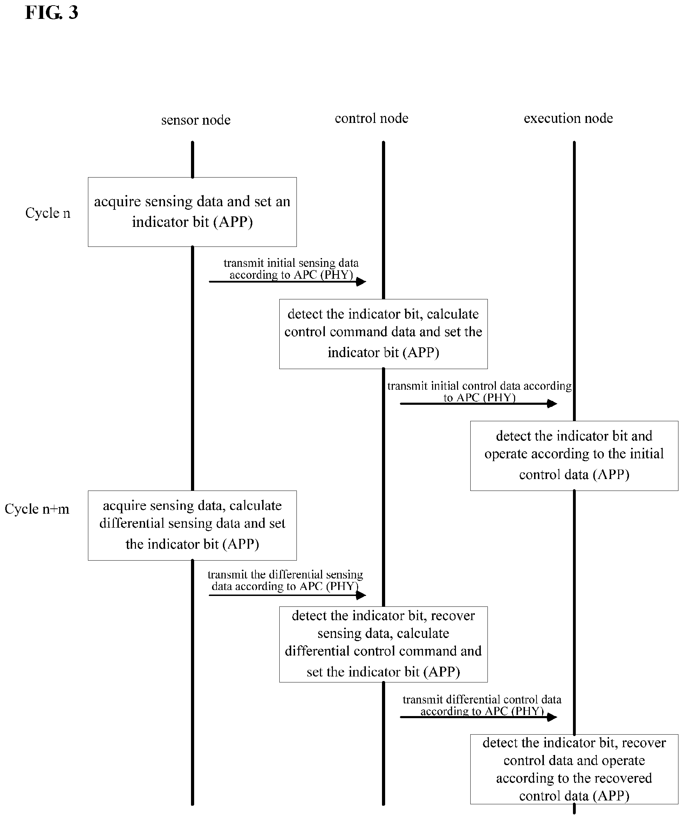

Figure 3 is a flow chart showing data differentiation performed at an application layer according to another embodiment.

As shown in Figure 3, in an n-th cycle (n≥1) for transmitting initial data, an APP layer of the sensor node acquires the sensing data and sets differential indication information (that may be 1-bit data) corresponding to the sensing data to 0 (for example, the differential indication information of 0 indicates that to-be-transmitted data is the initial data acquired in the current cycle, and the differential indication information of 1 indicates that the to-be-transmitted data is differential data of the initial data acquired in the current cycle). According to the adaptive power control scheme shown in Figure 8, in a case that the APP layer of the sensor node detects that the differential indication information is 0 and further determines that power indication information (that may be 1-bit data, and may be set to 0 or 1 to distinguish two states) is 0 (for example, the power indication information of 0 indicates that data is transmitted at the lower power, and the power indication information of 1 indicates that data is transmitted at the higher power), or in a case that the APP layer of the sensor node only detects that the differential indication information is 0, when the differential indication information or the power indication information is determined to be 0, the PHY layer of the sensor node transmits, to the control node, initial sensing data and the differential indication information corresponding to the sensing data (as well as the power indication information as needed) at the lower power. The differential indication information is set in a header of a data packet of a corresponding layer to indicate whether the data packet is the initial data or the differential data. Here, instead of the power indication information, the differential indication information may be used to indicate both a type of the transmitted data and power used for transmitting the data. In this way, power information may be acquired based on the differential indication information if the power information is needed in subsequent communication. However, it is not redundant to set different indication information to respectively indicate the type of the transmitted data and the power used for transmitting the data, because in some application scenarios or application requirements, indication information may be set in different manners from the above examples, and setting different indication information may reduce data transmission in some application scenarios.

At the control node, the APP layer of the control node determines that the received differential indication information corresponding to the sensing data is equal to 0, and thereby determines that the received sensing data is the initial sensing data. Therefore, the APP layer of the control node calculates control command data based on the received initial sensing data, and sets the differential indication information corresponding to the control command data to 0. Further, according to the adaptive power control scheme shown in Figure 8, the PHY layer of the control node transmits the initial control command data at the lower power based on the differential indication information corresponding to the control command data or the received power indication information.

At the execution node, an APP layer of the execution node (that may be located at the same device as the sensor node) determines that the differential indication information corresponding to the control command data is 0, and thus determined that the received control command is an initial control command. then the APP layer of the execution node performs operations according to the received initial control command data.

In an (n+m)-th cycle (1≤m≤N-1) for transmitting differential data, the APP layer of the sensor node acquires the sensing data, calculates a difference between sensing data acquired in the (n+m)-th cycle and the initial sensing data acquired in the n-th cycle to obtain differential sensing data, and sets the differential indication information corresponding to the sensing data to 1 (for example, the differential indication information of 0 indicates that the to-be-transmitted data is the initial data acquired in the current cycle, and the differential indication information of 1 indicates that the to-be-transmitted data is differential data of the initial data acquired in the current cycle). According to the adaptive power control scheme shown in Figure 8, in a case that the APP layer of the sensor node detects that the differential indication information is 1 and further determines that power indication information (that may be 1-bit data, and may be set to 0 or 1 to distinguish two states) is 1 (for example, the power indication information of 0 indicates that data is transmitted at the lower power, and the power indication information of 1 indicates that data is transmitted at the higher power), or in a case that the APP layer of the sensor node only detects that the differential indication information is 1, when the differential indication information or the power indication information is determined to be 1, the PHY layer of the sensor node transmits, to the control node, the initial sensing data and the differential indication information corresponding to the sensing data (as well as the power indication information as needed) at the higher power. The differential indication information is set in a header of a data packet of a corresponding layer to indicate whether the data packet is the initial data or the differential data. Here, instead of the power indication information, the differential indication information may be used to indicate both a type of the transmitted data and power used for transmitting the data. In this way, power information may be acquired based on the differential indication information if the power information is needed in subsequent communication. However, it is not redundant to set different indication information to respectively indicate the type of the transmitted data and the power used for transmitting the data, because in some application scenarios or application requirements, indication information may be set in different manners from the above examples, and setting different indication information may reduce data transmission in some application scenarios.

At the control node, the APP layer of the control node determines that the received indicator bit corresponding to the sensing data is equal to 1, and thereby determines that the received sensing data is the differential sensing data. Accordingly, it recovers the initial sensing data in the (n+m)-th cycle based on the received differential sensing data and the initial sensing data in the n-th cycle, calculates initial control command data in the (n+m)-th cycle and then calculates a difference between said initial control command data and initial control command data in the n-th cycle to obtain differential control command data, and sets an indicator bit corresponding to the control command data to 1. According to the adaptive power control scheme shown in Figure 8, the PHY layer of the control node transmits the differential control command data at the higher power based on the differential indication information corresponding to the control command data or the received power indication information.

At the execution node, the APP layer of the execution node (that may be located at the same device as the sensor node) determines that the indicator bit corresponding to the control command data is 1. It recovers control command data in the (n+m)-th cycle according to the received differential control command data and initial control command data in the n-th cycle, and then performs operations accordingly.

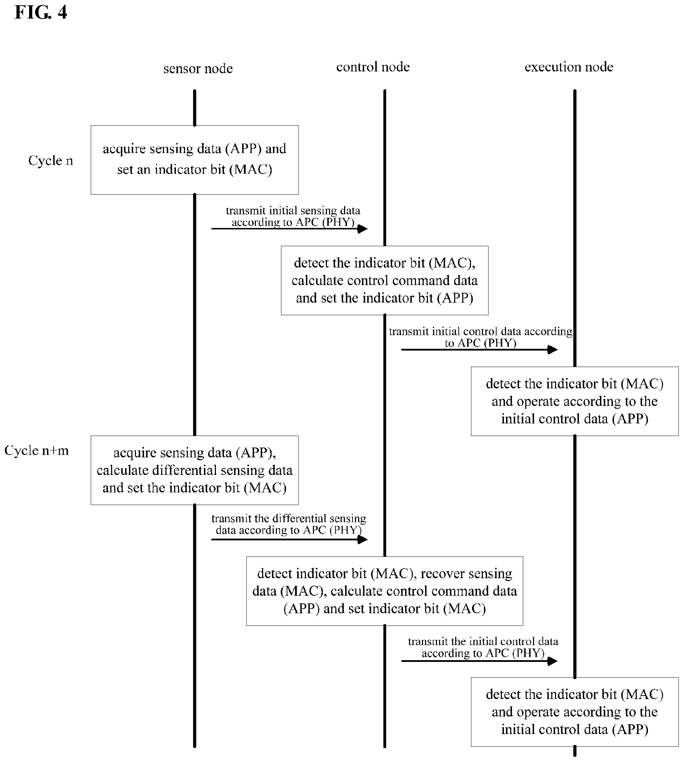

Figure 4 is a flow chart showing data differentiation performed at a medium access control layer according to an embodiment.

As shown in Figure 4, in an n-th cycle (n≥1) for transmitting initial data, an APP layer of the sensor node acquires the sensing data, and an MAC layer of the sensor node sets differential indication information (that may be 1-bit data) corresponding to the sensing data to 0 (for example, the differential indication information of 0 indicates that to-be-transmitted data is the initial data acquired in the current cycle, and the differential indication information of 1 indicates that the to-be-transmitted data is differential data of the initial data acquired in the current cycle). According to the adaptive power control scheme shown in Figure 8, in a case that the MAC layer of the sensor node detects that the differential indication information is 0 and further determines that power indication information (that may be 1-bit data, and may be set to 0 or 1 to distinguish two states) is 0 (for example, the power indication information of 0 indicates that data is transmitted at the lower power, and the power indication information of 1 indicates that data is transmitted at the higher power), or in a case that the MAC layer of the sensor node only detects that the differential indication information is 0, when the differential indication information or the power indication information is determined to be 0, the PHY layer of the sensor node transmits, to the control node, initial sensing data and the differential indication information corresponding to the sensing data (as well as the power indication information as needed) at the lower power. The differential indication information is set in a header of a data packet of a corresponding layer to indicate whether the data packet is the initial data or the differential data. Here, instead of the power indication information, the differential indication information may be used to indicate both a type of the transmitted data and power used for transmitting the data. In this way, power information may be acquired based on the differential indication information if the power information is needed in subsequent communication. However, it is not redundant to set different indication information to respectively indicate the type of the transmitted data and the power used for transmitting the data, because in some application scenarios or application requirements, indication information may be set in different manners from the above examples, and setting different indication information may reduce data transmission in some application scenarios.

At the control node, the MAC layer of the control node determines that the received differential indication information corresponding to the sensing data is equal to 0, and thereby determines that the received sensing data is the initial sensing data. Therefore, the APP layer of the control node calculates initial control command data based on the received initial sensing data, and the MAC layer of the control node sets the differential indication information corresponding to the control command data to 0. The PHY layer of the control node transmits the initial control command data at the lower power according to the adaptive power control scheme shown in Figure 8.

At the execution node, an MAC layer of the execution node (that may be located at the same device as the sensor node) determines that the differential indication information corresponding to the control command data is 0, and thus determines that the received control command is an initial control command. Then an APP layer of the execution node performs operations according to the received initial control command data.

In an (n+m)-th cycle (1≤m≤N-1) for transmitting differential data, the APP layer of the sensor node acquires the sensing data, and the MAC layer of the sensor node calculates a difference between sensing data acquired in the (n+m)-th cycle and the initial sensing data acquired in the n-th cycle to obtain differential sensing data, and sets the differential indication information corresponding to the sensing data to 1 (for example, the differential indication information of 0 indicates that the to-be-transmitted data is the initial data acquired in the current cycle, and the differential indication information of 1 indicates that the to-be-transmitted data is differential data of the initial data acquired in the current cycle). According to the adaptive power control scheme shown in Figure 8, in a case that the MAC layer of the sensor node detects that the differential indication information is 1 and further determines that power indication information (that may be 1-bit data, and may be set to 0 or 1 to distinguish two states) is 1 (for example, the power indication information of 0 indicates that data is transmitted at the lower power, and the power indication information of 1 indicates that data is transmitted at the higher power), or in a case that the MAC layer of the sensor node only detects that the differential indication information is 1, when the differential indication information or the power indication information is determined to be 1, the PHY layer of the sensor node transmits, to the control node, the initial sensing data and the differential indication information corresponding to the sensing data (as well as the power indication information as needed) at the higher power. The differential indication information is set in a header of a data packet of a corresponding layer to indicate whether the data packet is the initial data or the differential data. Here, instead of the power indication information, the differential indication information may be used to indicate both a type of the transmitted data and power used for transmitting the data. In this way, power information may be acquired based on the differential indication information if the power information is needed in subsequent communication. However, it is not redundant to set different indication information to respectively indicate the type of the transmitted data and the power used for transmitting the data, because in some application scenarios or application requirements, indication information may be set in different manners from the above examples, and setting different indication information may reduce data transmission in some application scenarios.

At the control node, the MAC layer of the control node determines that the received differential indication information corresponding to the sensing data is equal to 1, and thereby determines that the received sensing data is the differential sensing data. Accordingly, it recovers the initial sensing data in the (n+m)-th cycle according to the received differential sensing data and the initial sensing data in the n-th cycle. The APP layer of the control node calculates the initial control command data in the (n+m)-th cycle. The MAC layer of the control node sets the differential indication information corresponding to the control command data to 0. The PHY layer of the control node transmits the initial control command data at the lower power according to the adaptive power control scheme shown in Figure 8.

At the execution node, the MAC layer of the execution node (that may be located at the same device as the sensor node) determines that the differential indication information corresponding to the control command data is 0, and thus determines that the received control command is the initial control command. Then the APP layer of the execution node performs operations according to the received initial control command data.

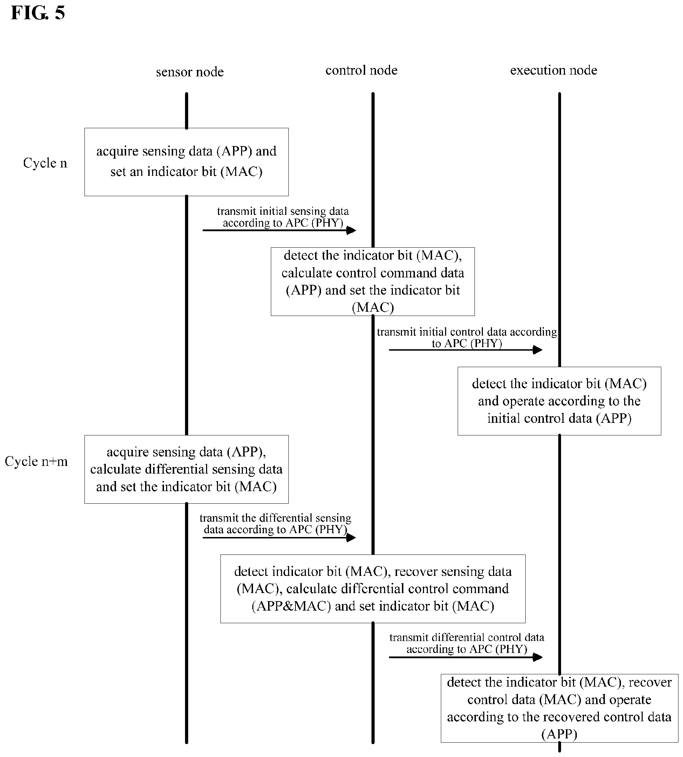

Figure 5 is a flow chart showing data differentiation performed at a medium access control layer according to another embodiment.

As shown in Figure 5, in an n-th cycle (n≥1) for transmitting initial data, an APP layer of the sensor node acquires the sensing data, and an MAC layer of the sensor node sets differential indication information (that may be 1-bit data) corresponding to the sensing data to 0 (for example, the differential indication information of 0 indicates that to-be-transmitted data is the initial data acquired in the current cycle, and the differential indication information of 1 indicates that the to-be-transmitted data is differential data of the initial data acquired in the current cycle). According to the adaptive power control scheme shown in Figure 8, in a case that the MAC layer of the sensor node detects that the differential indication information is 0 and further determines that differential power indication information (that may be 1-bit data, and may be set to 0 or 1 to distinguish two states) is 0 (for example, the power indication information of 0 indicates that data is transmitted at the lower power, and the power indication information of 1 indicates that data is transmitted at the higher power), or in a case that the MAC layer of the sensor node only detects that the differential indication information is 0, when the differential indication information or the power indication information is determined to be 0, the PHY layer of the sensor node transmits, to the control node, initial sensing data and the differential indication information corresponding to the sensing data (as well as the power indication information as needed) at the lower power. The differential indication information is set in a header of a data packet of a corresponding layer to indicate whether the data packet is the initial data or the differential data. Here, instead of the power indication information, the differential indication information may be used to indicate both a type of the transmitted data and power used for transmitting the data. In this way, power information may be acquired based on the differential indication information if the power information is needed in subsequent communication. However, it is not redundant to set different indication information to respectively indicate the type of the transmitted data and the power used for transmitting the data, because in some application scenarios or application requirements, indication information may be set in different manners from the above examples, and setting different indication information may reduce data transmission in some application scenarios.

At the control node, the MAC layer of the control node determines that the received differential indication information corresponding to the sensing data is equal to 0, and thereby determines that the received sensing data is the initial sensing data. Therefore, the APP layer of the control node calculates initial control command data based on the received initial sensing data, and the MAC layer of the control node sets the differential indication information corresponding to the control command data to 0. Further, according to the adaptive power control scheme shown in Figure 8, the PHY layer of the control node transmits the initial control command data at the lower power based on the differential indication information corresponding to the control command data or the received power indication information.

The MAC layer of the execution node (that may be located at the same device as the sensor node) determines that the differential indication information corresponding to the control command data is 0, and thus determines that the received control command is an initial control command. Then an APP layer of the execution node performs operations according to the received initial control command data.

In an (n+m)-th cycle (1≤m≤N-1) for transmitting differential data, the MAC layer of the sensor node acquires the sensing data, and calculates a difference between data acquired in the (n+m)-th cycle and the initial sensing data acquired in the n-th cycle to obtain differential sensing data, and sets the differential indication information corresponding to the sensing data to 1 (for example, the differential indication information of 0 indicates that the to-be-transmitted data is the initial data acquired in the current cycle, and the differential indication information of 1 indicates that the to-be-transmitted data is differential data of the initial data acquired in the current cycle). According to the adaptive power control scheme shown in Figure 8, in a case that the MAC layer of the sensor node detects that the differential indication information is 1 and further determines that power indication information (that may be 1-bit data, and may be set to 0 or 1 to distinguish two states) is 1 (for example, the power indication information of 0 indicates that data is transmitted at the lower power, and the power indication information of 1 indicates that data is transmitted at the higher power), or in a case that the MAC layer of the sensor node only detects that the differential indication information is 1, when the differential indication information or the power indication information is determined to be 1, the PHY layer of the sensor node transmits, to the control node, the initial sensing data and the differential indication information corresponding to the sensing data (as well as the power indication information as needed) at the higher power. The differential indication information is set in a header of a data packet of a corresponding layer to indicate whether the data packet is the initial data or the differential data. Here, instead of the power indication information, the differential indication information may be used to indicate both a type of the transmitted data and power used for transmitting the data. In this way, power information may be acquired based on the differential indication information if the power information is needed in subsequent communication. However, it is not redundant to set different indication information to respectively indicate the type of the transmitted data and the power used for transmitting the data, because in some application scenarios or application requirements, indication information may be set in different manners from the above examples, and setting different indication information may reduce data transmission in some application scenarios.

At the control node, the MAC layer of the control node determines that the received indicator bit corresponding to the sensing data is equal to 1, and thereby determines that the received sensing data is the differential sensing data. It recovers the initial sensing data in the (n+m)-th cycle based on the received differential sensing data and the initial sensing data in the n-th cycle. The APP layer of the control node calculates the initial control command data in the (n+m)-th cycle. The MAC layer of the control node calculates a difference between said initial control command data and initial control command data in the n-th cycle to obtain the differential control command data, and sets the indicator bit corresponding to the control command data to 1. According to the adaptive power control scheme shown in Figure 8, the PHY layer of the control node transmits the differential control command data at the higher power based on the differential indication information corresponding to the control command data or the received power indication information.

At the execution node, the MAC layer of the execution node (that may be located at the same device as the sensor node) determines that the indicator bit corresponding to the control command data is 1. The MAC layer of the execution node recovers control command data in the (n+m)-thcycle based on the received differential control command data and initial control command data in the n-th cycle. The APP layer of the execution node performs operations accordingly.

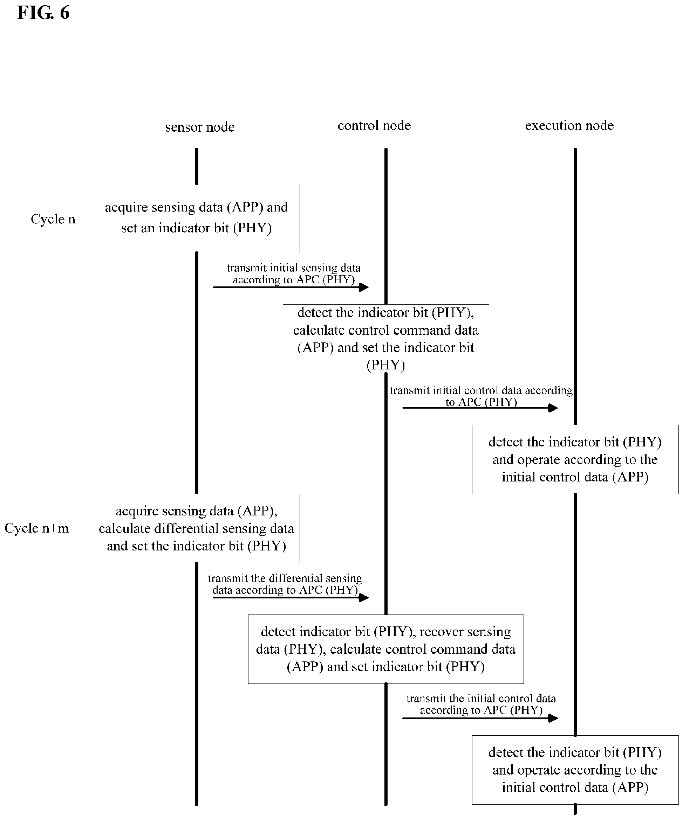

Figure 6 is a flow chart showing data differentiation performed at a physical layer according to an embodiment.

As shown in Figure 6, in an n-th cycle (n≥1) for transmitting initial data, an APP layer of the sensor node acquires the sensing data, and an PHY layer of the sensor node sets differential indication information (that may be 1-bit data) corresponding to the sensing data to 0 (for example, the differential indication information of 0 indicates that to-be-transmitted data is the initial data acquired in the current cycle, and the differential indication information of 1 indicates that the to-be-transmitted data is differential data of the initial data acquired in the current cycle). According to the adaptive power control scheme shown in Figure 8, in a case that the PHY layer of the sensor node detects that the differential indication information is 0 and further determines that power indication information (that may be 1-bit data, and may be set to 0 or 1 to distinguish two states) is 0 (for example, the power indication information of 0 indicates that data is transmitted at the lower power, and the power indication information of 1 indicates that data is transmitted at the higher power), or in a case that the PHY layer of the sensor node only detects that the differential indication information is 0, when the differential indication information or the power indication information is determined to be 0, the PHY layer of the sensor node transmits, to the control node, initial sensing data and the differential indication information corresponding to the sensing data (as well as the power indication information as needed) at the lower power. The differential indication information is set in a header of a data packet of a corresponding layer to indicate whether the data packet is the initial data or the differential data. Here, instead of the power indication information, the differential indication information may be used to indicate both a type of the transmitted data and power used for transmitting the data. In this way, power information may be acquired based on the differential indication information if the power information is needed in subsequent communication. However, it is not redundant to set different indication information to respectively indicate the type of the transmitted data and the power used for transmitting the data, because in some application scenarios or application requirements, indication information may be set in different manners from the above examples, and setting different indication information may reduce data transmission in some application scenarios.

At the control node, the PHY layer of the control node determines that the received differential indication information corresponding to the sensing data is equal to 0, and thereby determines that the received sensing data is the initial sensing data. Therefore, the APP layer of the control node calculates initial control command data based on the received initial sensing data. The PHY layer of the control node sets the differential indication information corresponding to the control command data to 0, and then transmits the initial control command data at the lower power according to the adaptive power control scheme shown in Figure 8.

The PHY layer of the execution node (that may be located at the same device as the sensor node) determines that the differential indication information corresponding to the control command data is 0, and thus determines that the received control command is an initial control command. Then an APP layer of the execution node performs operations according to the received initial control command data.

In an (n+m)-th cycle (1≤m≤N-1) for transmitting differential data, the APP layer of the sensor node acquires the sensing data, and calculates a difference between sensing data acquired in the (n+m)-th cycle and the initial sensing data acquired in the n-th cycle to obtain differential sensing data, and sets the differential indication information corresponding to the sensing data to 1 (for example, the differential indication information of 0 indicates that the to-be-transmitted data is the initial data acquired in the current cycle, and the differential indication information of 1 indicates that the to-be-transmitted data is differential data of the initial data acquired in the current cycle). According to the adaptive power control scheme shown in Figure 8, in a case that the PHY layer of the sensor node detects that the differential indication information is 1 and further determines that power indication information (that may be 1-bit data, and may be set to 0 or 1 to distinguish two states) is 1 (for example, the power indication information of 0 indicates that data is transmitted at the lower power, and the power indication information of 1 indicates that data is transmitted at the higher power), or in a case that the PHY layer of the sensor node only detects that the differential indication information is 1, when the differential indication information or the power indication information is determined to be 1, the PHY layer of the sensor node transmits, to the control node, the initial sensing data and the differential indication information corresponding to the sensing data (as well as the power indication information as needed) at the higher power. The differential indication information is set in a header of a data packet of a corresponding layer to indicate whether the data packet is the initial data or the differential data. Here, instead of the power indication information, the differential indication information may be used to indicate both a type of the transmitted data and power used for transmitting the data. In this way, power information may be acquired based on the differential indication information if the power information is needed in subsequent communication. However, it is not redundant to set different indication information to respectively indicate the type of the transmitted data and the power used for transmitting the data, because in some application scenarios or application requirements, indication information may be set in different manners from the above examples, and setting different indication information may reduce data transmission in some application scenarios.

At the control node, the PHY layer of the control node determines that the received indication bit corresponding to the sensing data is equal to 1, and thereby determines that the received sensing data is the differential sensing data. The PHY layer of the control node recovers the initial sensing data in the (n+m)-th cycle according to the received differential sensing data and the initial sensing data in the n-th cycle. The APP layer of the control node calculates initial control command data in the (n+m)-th cycle. The PHY layer of the control node sets the differential indication information corresponding to the control command data to 0. The PHY layer of the control node transmits the differential control command data at the lower power according to the adaptive power control scheme shown in Figure 8.

The PHY layer of the execution node (that may be located at the same device as the sensor node) determines that the differential indication information corresponding to the control command data is 0, and thus determines that the received control command is the initial control command. Then the APP layer of the execution node performs operations according to the received initial control command data.

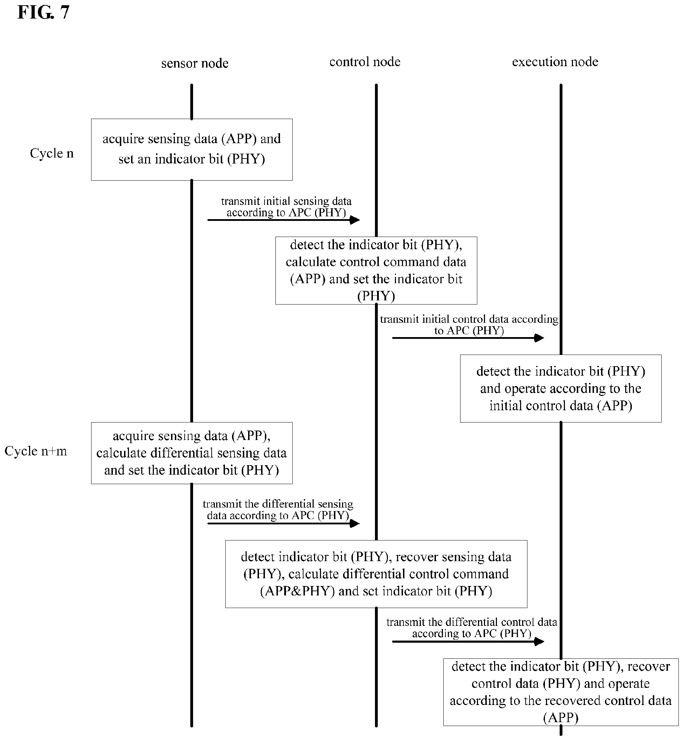

Figure 7 is a flow chart showing data differentiation performed at a physical layer according to another embodiment.

As shown in Figure 7, in an n-th cycle (n≥1) for transmitting initial data, an APP layer of the sensor node acquires the sensing data, and an PHY layer of the sensor node sets differential indication information (that may be 1-bit data) corresponding to the sensing data to 0 (for example, the differential indication information of 0 indicates that to-be-transmitted data is the initial data acquired in the current cycle, and the differential indication information of 1 indicates that the to-be-transmitted data is differential data of the initial data acquired in the current cycle). According to the adaptive power control scheme shown in Figure 8, in a case that the PHY layer of the sensor node detects that the differential indication information is 0 and further determines that power indication information (that may be 1-bit data, and may be set to 0 or 1 to distinguish two states) is 0 (for example, the power indication information of 0 indicates that data is transmitted at the lower power, and the power indication information of 1 indicates that data is transmitted at the higher power), or in a case that the PHY layer of the sensor node only detects that the differential indication information is 0, when the differential indication information or the power indication information is determined to be 0, the PHY layer of the sensor node transmits, to the control node, initial sensing data and the differential indication information corresponding to the sensing data (as well as the power indication information as needed) at the lower power. The differential indication information is set in a header of a data packet of a corresponding layer to indicate whether the data packet is the initial data or the differential data. Here, instead of the power indication information, the differential indication information may be used to indicate both a type of the transmitted data and power used for transmitting the data. In this way, power information may be acquired based on the differential indication information if the power information is needed in subsequent communication. However, it is not redundant to set different indication information to respectively indicate the type of the transmitted data and the power used for transmitting the data, because in some application scenarios or application requirements, indication information may be set in different manners from the above examples, and setting different indication information may reduce data transmission in some application scenarios.

At the control node, the PHY layer of the control node determines that the received differential indication information corresponding to the sensing data is equal to 0, and thereby determines that the received sensing data is the initial sensing data. Therefore, the APP layer of the control node calculates control command data based on the received initial sensing data, and sets the differential indication information corresponding to the control command data to 0. According to the adaptive power control scheme shown in Figure 8, the PHY layer of the control node transmits the initial control command data at the lower power according to the differential indication information corresponding to the control command data or the received power indication information.

The PHY layer of the execution node (that may be located at the same device as the sensor node) determines that the differential indication information corresponding to the control command data is 0, and thus determines that the received control command is an initial control command. Then an APP layer of the execution node performs operations according to the received initial control command data.

In an (n+m)-th cycle (1≤m≤N-1) for transmitting differential data, the APP layer of the sensor node acquires the sensing data, and the PHY layer of the sensor node calculates a difference between sensing data acquired in the (n+m)-th cycle and the initial sensing data acquired in the n-th cycle to obtain differential sensing data, and sets the differential indication information corresponding to the sensing data to 1 (for example, the differential indication information of 0 indicates that the to-be-transmitted data is the initial data acquired in the current cycle, and the differential indication information of 1 indicates that the to-be-transmitted data is differential data of the initial data acquired in the current cycle). According to the adaptive power control scheme shown in Figure 8, in a case that the PHY layer of the sensor node detects that the differential indication information is 1 and further determines that power indication information (that may be 1-bit data, and may be set to 0 or 1 to distinguish two states) is 1 (for example, the power indication information of 0 indicates that data is transmitted at the lower power, and the power indication information of 1 indicates that data is transmitted at the higher power), or in a case that the PHY layer of the sensor node only detects that the differential indication information is 1, when the differential indication information or the power indication information is determined to be 1, the PHY layer of the sensor node transmits, to the control node, the initial sensing data and the differential indication information corresponding to the sensing data (as well as the power indication information as needed) at the higher power. The differential indication information is set in a header of a data packet of a corresponding layer to indicate whether the data packet is the initial data or the differential data. Here, instead of the power indication information, the differential indication information may be used to indicate both a type of the transmitted data and power used for transmitting the data. In this way, power information may be acquired based on the differential indication information if the power information is needed in subsequent communication. However, it is not redundant to set different indication information to respectively indicate the type of the transmitted data and the power used for transmitting the data, because in some application scenarios or application requirements, indication information may be set in different manners from the above examples, and setting different indication information may reduce data transmission in some application scenarios.

At the control node, the PHY layer of the control node determines that the received indicator bit corresponding to the sensing data is equal to 1, and thereby determines that the received sensing data is the differential sensing data. it recovers the initial sensing data in the (n+m)-th cycle based on the received differential sensing data and the initial sensing data in the n-th cycle. The APP layer of the control node calculates initial control command data in the (n+m)-th cycle, and calculates a difference between said initial control command data and initial control command data in the n-th cycle to obtain the differential control command data, and sets indicator bit corresponding to the control command data to 1. According to the adaptive power control scheme shown in Figure 8, the PHY layer of the control node transmits the differential control command data at the higher power based on the differential indication information corresponding to the control command data or the received power indication information.

The PHY layer of the execution node (that may be located at the same device as the sensor node) determines that the indicator bit corresponding to the control command data is 1, and recovers the control command data in the (n+m)-th cycle based on the received differential control command data and the initial control command data in the n-th cycle. Then the APP layer of the execution node performs operations accordingly.

Figure 8 is a flow chart showing adaptive power control according to an embodiment of the present disclosure. In step 801, an indicator bit is detected. The indicator bit may be the differential indication information or the power indication information as described above. If the indicator bit is detected as 1 in step 802, process proceeds to step 803. In step 803, data is transmitted at the higher power. If the indicator bit is detected as 0, process proceeds to step 804. In step 804, the data is transmitted at the lower power. The differential data has a small data size and a low error tolerance rate and therefore is transmitted with the higher power to reduce the bit error rate. In addition, the original data with a large data size has a high error tolerance rate and therefore is transmitted at the low power. In view of this, the power is selected according to the data type.

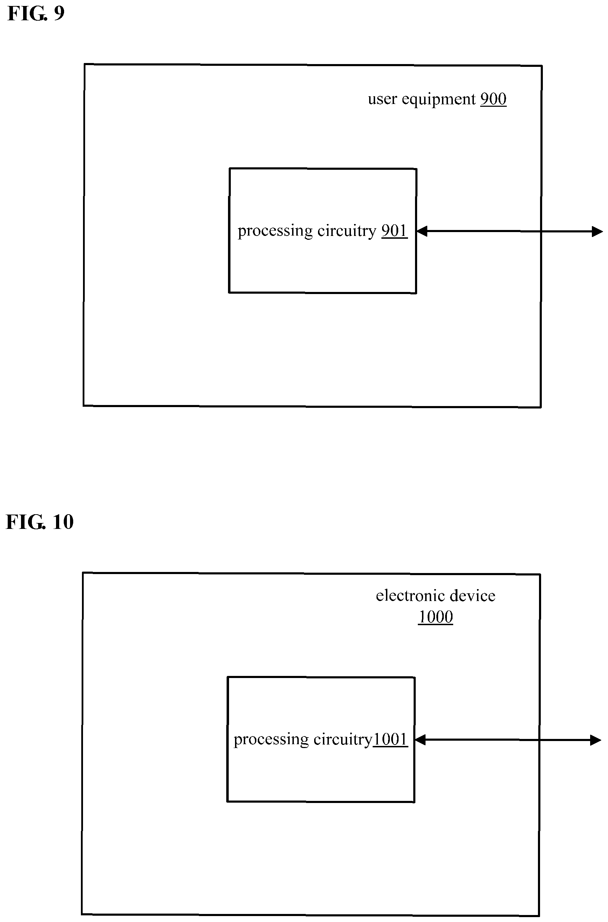

Next, structures of devices in the industrial Internet of Things scenario shown in Figure 1 are described with reference to Figures 9 and 10. The operations that the processing circuitry of user equipment 900 shown in Figure 9 is configured to perform may be understood with reference to the communication methods shown in Figures 2 to 7.

Figure 9 is a structural block diagram showing user equipment 900 according to an embodiment of the present disclosure. As shown in Figure 9, the user equipment 900 includes processing circuitry 901. The processing circuitry 901 is configured to transmit first data with first transmission power within a first period of time, and transmit differential data of the first data with second transmission power within a second period of time. The differential data is a difference between second data expected to be transmitted within the second period of time and the first data. The first data herein may be initial data expected to be transmitted within the first period of time, or the differential data. In a case that the first data is the initial data, the second data is differential data of the initial data. In a case that the first data is the differential data, the second data is differential data of the differential data. The first data and the second data may be acquired by the user equipment. The second period of time may be after the first period of time. Further, the first period of time may be followed by M consecutive second periods of time. M is an integer greater than or equal to 1. For example, Packet#0 is used for transmitting the initial data packet, and Packets#1~#M are used for transmitting the results of differential operation with respect to the Packet#0. The second transmission power may be greater than the first transmission power. The differential data has a small size and a low error tolerance rate and therefore is transmitted with higher power to reduce bit error rate. In addition, the original data with a large size has a high error tolerance rate and therefore is transmitted at lower power.

The processing circuitry 901 of the user equipment 900 according to an embodiment of the present disclosure is further configured to transmit differential indication information to indicate whether data being currently transmitted is the differential data, and transmit power indication information to indicate current transmission power.

The processing circuitry 901 of the user equipment 900 according to an embodiment of the present disclosure is further configured to acquire period indication information indicating the first period of time and the second period of time. Referring to Figures 2 to 7, the cycle n (n≥1) and the cycle (n+m) (1≤m≤N-1) are determined in advance in processes of Figures 2 to 7. The period indication information indicating the period for transmitting the initial data and the period indication information indicating period for transmitting the differential data may be acquired in advance by the processing circuitry of the electronic device 900 serving as the user equipment.

The processing circuitry 901 of the user equipment 900 according to an embodiment of the present disclosure is further configured to acquire information on calculation of the differential data and perform corresponding calculation according to the information. The information comprises one of: not calculating the differential data; calculating the differential data at a physical layer; calculating the differential data at a medium access control layer; and calculating the differential data at an application layer. Referring to Figures 2 to 7, the cases of calculating the differential data at different layers and not calculating the differential data are described in processes of Figures 2 to 7. In practices, the information may be acquired by the processing circuitry of the user equipment according to the application scenario to calculate the differential data at a specific layer or not to calculate the differential data in the communication with, for example, gNB

The user equipment 900 according to the embodiment of the present disclosure transmits the differential indication information in at least one of the following manners: transmitting through a physical downlink control channel (PDCCH) and/or a physical uplink control channel (PUCCH) of a physical layer; transmitting through a dedicated control channel (DCCH) of a medium access control layer; and transmitting through control signaling of an application layer.

The processing circuitry 901 of the user equipment 900 according to an embodiment of the present disclosure is further configured to acquire information on resources used for data transmission, and the resources include frequency domain or code domain.

The processing circuitry 901 of the user equipment 900 according to an embodiment of the present disclosure is further configured to configure periods of time for data transmission and resources used for the data transmission. The configuration may be performed for each data packet, and the configuration may also be performed by taking M periods of time as a cycle.

According to the user equipment 900 in the embodiment of the present disclosure, the transmission power is set by the user equipment or a system including the user equipment.

The processing circuitry 901 of the user equipment 900 according to an embodiment of the present disclosure is further configured to receive first control command data for the first data within the first period of time, and receive second control command data for the second data within the second period of time. The first control command data is initial control command data, and the second control command data is differential data of the first control command data or the initial control command data. The differential data is a difference between the second control command data received within the second period of time and the first control command data.

The processing circuitry 901 of the user equipment 900 according to an embodiment of the present disclosure is further configured to transmit the data immediately after acquisition of the data or delay the transmission a predetermined time, or transmit the data in response to a request from another user equipment. According to different application scenarios or application requirements, after the sensing data is acquired, a buffer of the user equipment 900 can transmit the data immediately or delay the transmission a predetermined time if necessary. In addition, the data may be transmitted in response to a request from another user equipment.

The processing circuitry 901 of the user equipment 900 according to an embodiment of the present disclosure is further configured to configure the data transmission by pre-configuration or system information configuration or RRC signaling configuration.

Figure 10 is a structural block diagram showing an electronic device 1000 according to an embodiment of the present disclosure. As shown in Figure 10, the electronic device 1000 includes processing circuitry 1001. The processing circuitry 1001 is configured to: receive first data as initial data within a first period of time, calculate first control command data based on the first data, and transmit the first control command data; receive differential data of the first data within a second period of time, wherein the differential data is a difference between initial data expected to be received within the second period of time and the first data; add the differential data and the first data to recover second data, calculate second control command data based on the second data, and transmit the second control command data. The second period of time may be after the first period of time. Further, the first period of time may be followed by M consecutive second periods of time. M is an integer greater than or equal to 1. For example, Packet#0 is used for receiving the initial data packet, and Packets#1~#M are used for receiving the results of differential operation with respect to the Packet#0.

The processing circuitry 1001 of the electronic device 1000 according to an embodiment of the present disclosure is further configured to receive differential indication information for indicating whether data being currently received is the differential data.

The processing circuitry 1001 of the electronic device 1000 according to an embodiment of the present disclosure is further configured to receive differential indication information indicating whether data being currently received is the differential data, and the operation of recovering the second data is triggered by the differential indication information. In a case that the differential indication information indicates that the data being currently received is the first data as the initial data, buffering of the first data in the buffer is triggered. In a case that the differential indication information indicates that the data being currently received is the differential data, the operation of recovering the second data based on the first data stored in the buffer and the differential data is triggered. The electronic device 1000 further includes a memory. The memory is configured to store the first data, the differential data and/or the recovered second data.

The processing circuitry 1001 of the electronic device 1000 according to an embodiment of the present disclosure is further configured to receive information on calculation of the differential data and perform the corresponding recovering operation according to the information. The information comprises one of: not calculating the differential data; calculating the differential data at a physical layer; calculating the differential data at a medium access control layer; and calculating the differential data at an application layer.

The processing circuitry 1001 of the electronic device 1000 according to an embodiment of the present disclosure is configured to receive the differential indication information in at least one of the following manners: receiving through a physical downlink control channel (PDCCH) and/or a physical uplink control channel (PUCCH) of a physical layer; receiving through a dedicated control channel (DCCH) of a medium access control layer; and receiving through control signaling of an application layer.

Herein, each unit of the user equipment 900 and the electronic device 1000 may be included in the processing circuitry. It should be noted that the user equipment 900 and the electronic device 1000 may include either one processing circuit or multiple processing circuits. Further, the processing circuitry may include various discrete functional units to perform various different functions and/or operations. It should be noted that these functional units may be physical entities or logical entities, and units with different names may be implemented by a same physical entity.

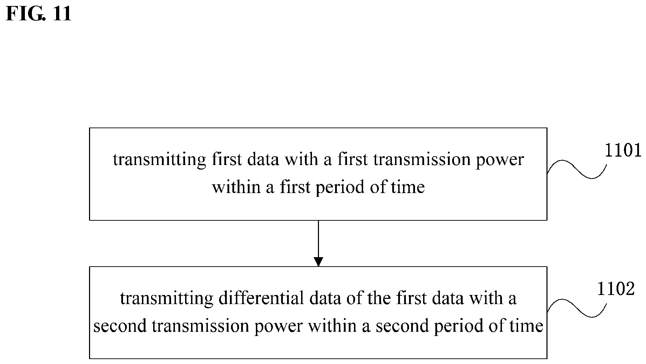

Figure 11 is a flow chart showing a wireless communication method performed by user equipment 900 according to an embodiment of the present disclosure. As shown in Figure 11, the wireless communication method performed by the user equipment 900 includes the following steps 1101 and 1102. In step 1101, first data is transmitted with first transmission power within a first period of time. In step 1102, differential data of the first data is transmitted with second transmission power within a second period of time. The differential data is a difference between second data expected to be transmitted within the second period of time and the first data.

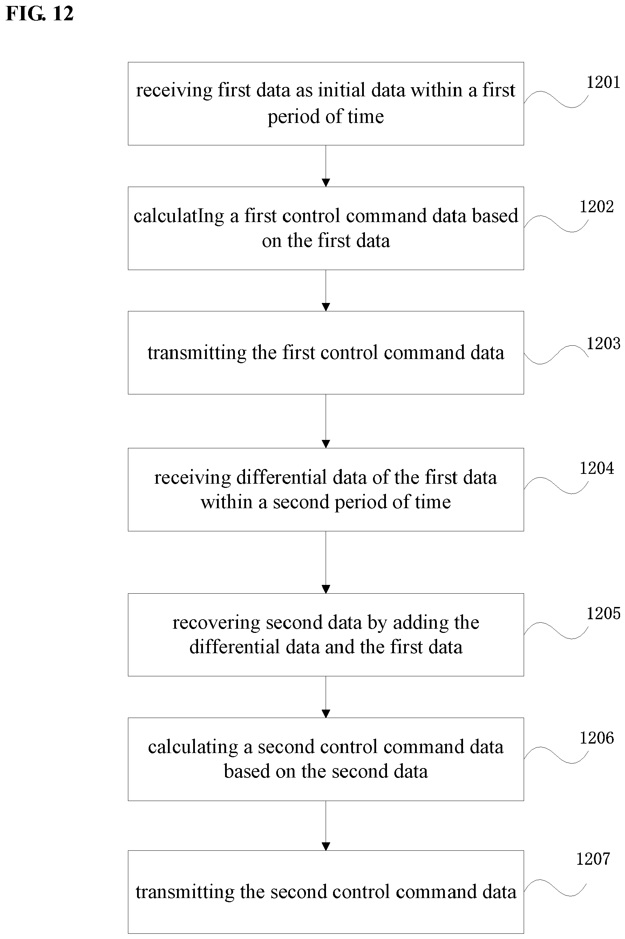

Figure 12 is a flow chart showing a wireless communication method performed by an electronic device 1000 according to an embodiment of the present disclosure. As shown in Figure 12, the wireless communication method performed by the electronic device 1000 includes the following steps 1201 to 1207. In step 1201, first data as initial data is received within a first period of time. In step 1202, first control command data is calculated based on the first data. In step 1203, the first control command data is transmitted. In step 1204, differential data of the first data is received within a second period of time, and the differential data is a difference between initial data expected to be received within the second period of time and the first data. In step 1205, the differential data and the first data are added to recover the second data. In step 1206, second control command data is calculated based on the second data. In step 1207, the second control command data is transmitted.

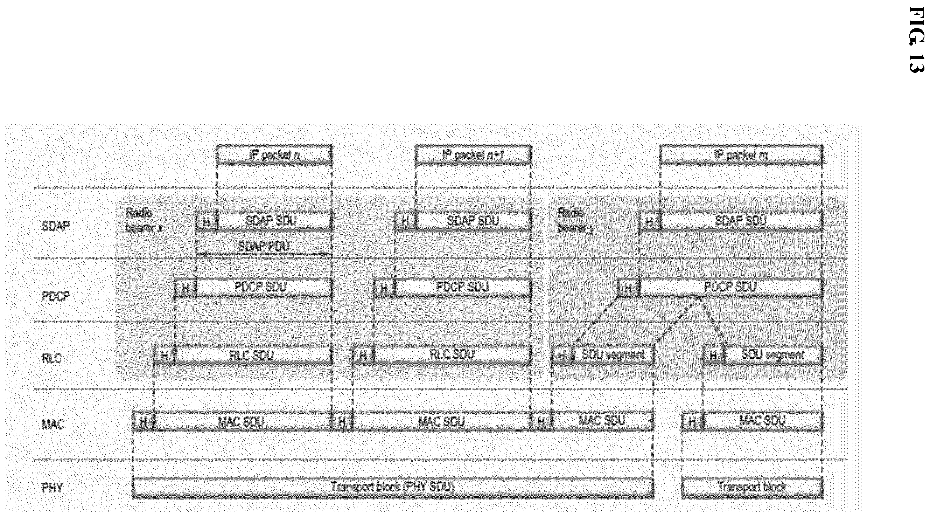

Figure 13 is a schematic diagram showing a data flow between layers of a 5G protocol stack according to an embodiment of the present disclosure. As a reference, concepts of resource configuration and setting a header of a data packet described above may be understood with reference to the data flow between layers of the protocol stack in Figure 13.

According to the embodiments of the present disclosure, time and resource configuration at least include: dynamic configuration method in which data packets are configured individually; and semi-static configuration in which periodic configuration is performed based on differential transmission frequency M according to the differential indication information in the data packet.

According to the embodiments of the present disclosure, the differential data may further be calculated by bit-wise exclusive-OR (XOR).

According to the embodiments of the present disclosure, acquisition and transmission of the sensing data is not limited to performed by the user equipment (UE), but may further be performed in response to a request from, for example, the gNB or other device to the user equipment (UE). In addition, the control command data calculated by the gNB is not necessarily transmitted to the UE (in a case that both the sensor node and the execution node are located in the UE), but may be transmitted to other devices (in a case that only the execution node is located in the UE) to perform operations.

To be specific, a sensor in the user equipment (UE) periodically senses the sensing data. The user equipment (UE) including the sensor transmits the data sensed by the sensor when a preset period of time elapses after the sensing data is sensed.

Alternatively, the sensor in the user equipment (UE) periodically senses the sensing data or senses the sensing data in response to an event triggered request (for example, from the gNB or other devices). The user equipment (UE) including the sensor transmits the data sensed by the sensor when a preset period of time elapses after the sensing data is sensed or in response to the same event triggered request. It should be noted that in this case, since the event triggered request may be discontinuous in time, change in the sensing data is large. Even if the differential transmission method is adopted, the amount of the transmitted data is increased compared with the above-stated case of periodically transmitting the sensing data.

In the case that the request is made by the gNB or other devices as described above, the gNB or other devices may initiate the request in response to a decision that is made based on the acquired sensing data after the needed sensing data is acquired.

In addition, the gNB or other devices may further trigger a request for the sensing data based on specific events. The events include but are not limited to various events in application scenarios of the industrial Internet of Things.

A computer-readable storage medium is further provided according to another embodiment of the present disclosure. The computer-readable storage medium may include executable computer instructions that, when executed by a computer, cause the computer to implement the methods according to the embodiments of the present disclosure.

The present disclosure may be applied to but not limited to the field of industrial Internet of Things, and may further be applied to other environments with ultra-low delay wireless communication requirements.

The technology of the present disclosure may be applied to various products. For example, the electronic device described in the present disclosure may be a base station. The base station may be implemented as gNB or any type of evolution Node B (eNB) in 5G environment, such as a macro eNB and a small eNB. The small eNB may be an eNB covering a cell smaller than a macro cell, such as a pico eNB, a micro eNB or a home (femto) eNB. Alternatively, the base station may be implemented as any other type of base station, such as a NodeB and a base transceiver station (BTS). The electronic device may include: a main body (also referred to as a base station apparatus) configured to control wireless communication; and one or more remote radio heads (RRH) arranged at positions different from the main body. In addition, various types of terminals described below may operate as a base station by performing functions of the base station temporarily or in a semi-persistent manner.

For example, the UE described in the present disclosure may be implemented as mobile terminals (such as a smart phone, a tablet personal computer (PC), a notebook PC, a portable game terminal, a portable/dongle mobile router and a digital camera) or a vehicle terminal (such as a vehicle navigation device). The UE may further be implemented as a terminal that performs machine to machine (M2M) communication (also referred to as a machine type communication (MTC) terminal). In addition, the UE may be a wireless communication module (such as an integrated circuit module including one chip) installed on each of the above terminals.

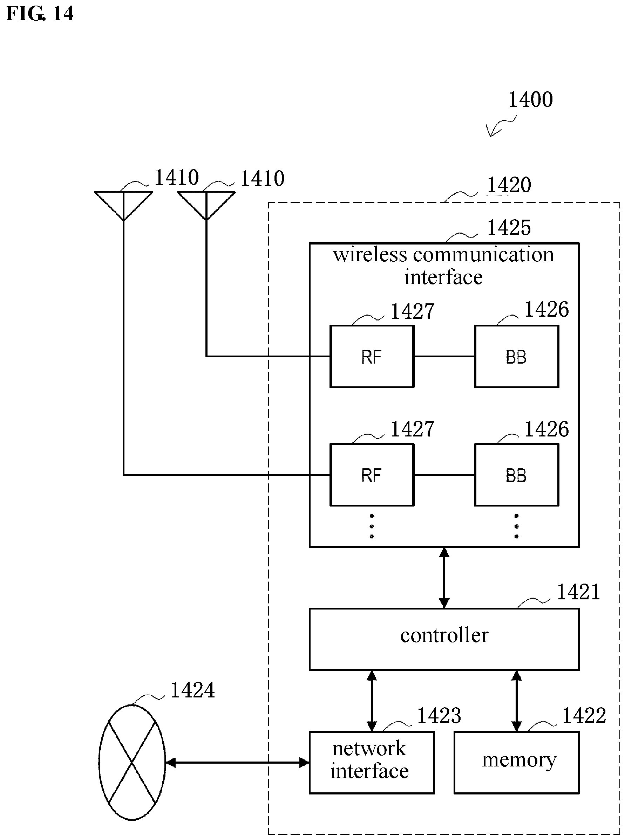

Figure 14 is a block diagram showing a first schematic configuration example of an eNB to which the technology of the present disclosure may be applied. An eNB 1400 may include one or more antennas 1410 and a base station apparatus 1420. The base station apparatus 1420 and each antenna 1410 may be connected to each other via an RF cable.

Each of the antennas 1410 includes a single or multiple antenna elements (such as multiple antenna elements included in a multi-input multi-output (MIMO) antenna), and is used for the base station apparatus 1420 to transmit and receive wireless signals. As shown in Figure 14, the eNB 1400 may include the multiple antennas 1410. For example, the multiple antennas 1410 may be compatible with multiple frequency bands used by the eNB 1400. Although Figure 14 shows the example in which the eNB 1400 includes the multiple antennas 1410, the eNB 1400 may also include a single antenna 1410.

The base station apparatus 1420 includes a controller 1421, a memory 1422, a network interface 1423, and a wireless communication interface 1425.

The controller 1421 may be, for example, a CPU or a DSP, and operates various functions of a higher layer of the base station apparatus 1420. For example, the controller 1421 generates a data packet from data in signals processed by the wireless communication interface 1425, and transfers the generated packet via the network interface 1423. The controller 1421 may bundle data from multiple base band processors to generate the bundled packet, and transfer the generated bundled packet. The controller 1421 may have logical functions of performing control such as radio resource control, radio bearer control, mobility management, admission control and scheduling. The control may be performed in corporation with an eNB or a core network node in the vicinity. The memory 1422 includes a RAM and a ROM, and stores a program executed by the controller 1421 and various types of control data (such as terminal list, transmission power data, and scheduling data).

The network interface 1423 is a communication interface for connecting the base station apparatus 1420 to a core network 1424. The controller 1421 may communicate with a core network node or another eNB via the network interface 1423. In this case, the eNB 1000, and the core network node or the other eNB may be connected to each other via a logical interface (such as an S1 interface and an X2 interface). The network interface 1423 may also be a wired communication interface or a wireless communication interface for wireless backhaul. If the network interface 1423 is a wireless communication interface, the network interface 1423 may use a higher frequency band for wireless communication than a frequency band used by the wireless communication interface 1425.

The wireless communication interface 1425 supports any cellular communication scheme (such as Long Term Evolution (LTE) and LTE-Advanced), and provides wireless connection to a terminal positioned in a cell of the eNB 1400 via the antenna 1410. The wireless communication interface 1425 may typically include, for example, a BB processor 1426 and an RF circuit 1427. The BB processor 1426 may perform, for example, encoding/decoding, modulating/demodulating, and multiplexing/demultiplexing, and performs various types of signal processing of layers (such as LI, medium access control (MAC), wireless link control (RLC), and a packet data convergence protocol (PDCP)). The BB processor 1426 may have a part or all of the above-described logical functions instead of the controller 1421. The BB processor 1426 may be a memory that stores a communication control program, or a module that includes a processor and a related circuit configured to execute the program. Updating the program may allow the functions of the BB processor 1426 to be changed. The module may be a card or a blade that is inserted into a slot of the base station apparatus 1420. Alternatively, the module may also be a chip that is mounted on the card or the blade. Meanwhile, the RF circuit 1427 may include, for example, a mixer, a filter, and an amplifier, and transmits and receives wireless signals via the antenna 1410.

As shown in Figure 14, the wireless communication interface 1425 may include the multiple BB processors 1426. For example, the multiple BB processors 1426 may be compatible with multiple frequency bands used by the eNB 1400. As shown in Figure 14, the wireless communication interface 1425 may include the multiple RF circuits 1427. For example, the multiple RF circuits 1427 may be compatible with multiple antenna elements. Although Figure 14 shows the example in which the wireless communication interface 1425 includes the multiple BB processors 1426 and the multiple RF circuits 1427, the wireless communication interface 1425 may also include a single BB processor 1426 or a single RF circuit 1427.

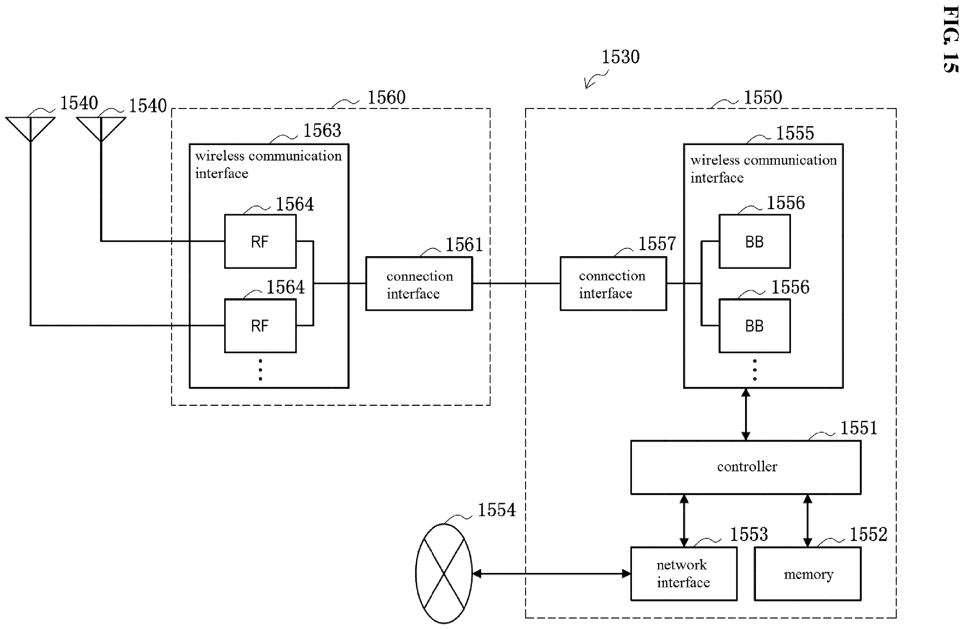

Figure 15 is a block diagram showing a second schematic configuration example of an eNB to which the technology of the present disclosure may be applied. An eNB 1530 includes one or more antennas 1540, a base station device 1550, and an RRH 1560. The RRH 1560 and each antenna 1540 may be connected to each other via an RF cable. The base station device 1550 and the RRH 1560 may be connected to each other via a high speed line such as an optical fiber cable.

Each of the antennas 1540 includes a single or multiple antenna elements (such as multiple antenna elements included in an MIMO antenna), and is used for the RRH 1560 to transmit and receive wireless signals. As shown in Figure 15, the eNB 1530 may include the multiple antennas 1540. For example, the multiple antennas 1540 may be compatible with multiple frequency bands used by the eNB 1530. Although Figure 15 shows the example in which the eNB 1530 includes the multiple antennas 1540, the eNB 1530 may also include a single antenna 1540.

The base station device 1550 includes a controller 1551, a memory 1552, a network interface 1553, a wireless communication interface 1555, and a connection interface 1557. The controller 1551, the memory 1552, and the network interface 1553 are the same as the controller 1421, the memory 1422, and the network interface 1423 described with reference to Figure 14.

The wireless communication interface 1555 supports any cellular communication scheme (such as LTE and LTE-Advanced), and provides wireless communication to a terminal positioned in a sector corresponding to the RRH 1560 via the RRH 1560 and the antenna 1540. The wireless communication interface 1555 may typically include, for example, a BB processor 1556. The BB processor 1556 is the same as the BB processor 1426 described with reference to Figure 14, except the BB processor 1556 is connected to an RF circuit 1564 of the RRH 1560 via the connection interface 1557. As shown in Figure 15, the wireless communication interface 1555 may include the multiple BB processors 1556. For example, the multiple BB processors 1556 may be compatible with multiple frequency bands used by the eNB 1530. Although Figure 15 shows the example in which the wireless communication interface 1555 includes the multiple BB processors 1556, the wireless communication interface 1555 may also include a single BB processor 1556.

The connection interface 1557 is an interface for connecting the base station device 1550 (wireless communication interface 1555) to the RRH 1560. The connection interface 1557 may also be a communication module for communication in the above-described high speed line that connects the base station device 1550 (wireless communication interface 1555) to the RRH 1560.

The RRH 1560 includes a connection interface 1561 and a wireless communication interface 1563.

The connection interface 1561 is an interface for connecting the RRH 1560 (wireless communication interface 1563) to the base station device 1550. The connection interface 1561 may also be a communication module for communication in the above-described high speed line.

The wireless communication interface 1563 transmits and receives wireless signals via the antenna 1540. The wireless communication interface 1563 may typically include, for example, the RF circuit 1564. The RF circuit 1564 may include, for example, a mixer, a filter, and an amplifier, and transmits and receives wireless signals via the antenna 1540. As shown in Figure 15, the wireless communication interface 1563 may include multiple RF circuits 1564. For example, the multiple RF circuits 1564 may support multiple antenna elements. Although Figure 15 shows the example in which the wireless communication interface 1563 includes the multiple RF circuits 1564, the wireless communication interface 1563 may also include a single RF circuit 1564.

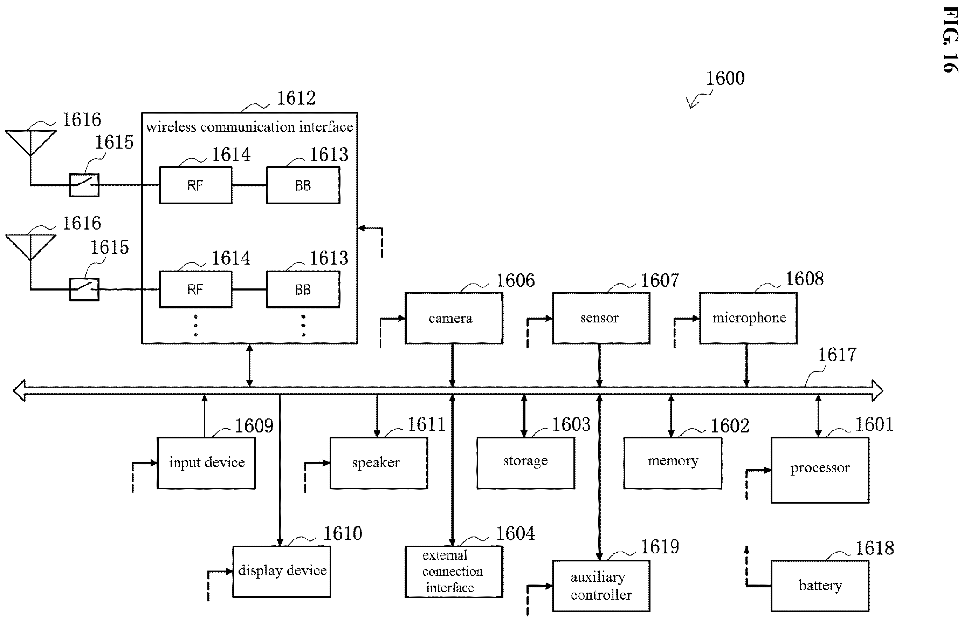

Figure 16 is a block diagram showing a schematic configuration example of a smart phone 1600 to which the technology of the present disclosure may be applied. The smart phone 1600 includes a processor 1601, a memory 1602, a storage 1603, an external connection interface 1604, a camera 1606, a sensor 1607, a microphone 1608, an input device 1609, a display device 1610, a speaker 1611, a wireless communication interface 1612, one or more antenna switches 1615, one or more antennas 1616, a bus 1617, a battery 1618, and an auxiliary controller 1619.

The processor 1601 may be, for example, a CPU or a system on a chip (SoC), and controls functions of an application layer and another layer of the smart phone 1600. The memory 1602 includes RAM and ROM, and stores a program executed by the processor 1601 and data. The storage 1603 may include a storage medium such as a semiconductor memory and a hard disk. The external connection interface 1604 is an interface for connecting an external apparatus (such as a memory card and a universal serial bus (USB) apparatus) to the smart phone 1600.

The camera 1606 includes an image sensor (such as a charge coupled device (CCD) and a complementary metal oxide semiconductor (CMOS)), and generates a captured image. The sensor 1607 may include a group of sensors such as a measurement sensor, a gyro sensor, a geomagnetic sensor, and an acceleration sensor. The microphone 1608 converts sounds that are inputted to the smart phone 1600 to audio signals. The input device 1609 includes, for example, a touch sensor configured to detect touch onto a screen of the display device 1610, a keypad, a keyboard, a button, or a switch, and receive an operation or information inputted from a user. The display device 1610 includes a screen (such as a liquid crystal display (LCD) and an organic light-emitting diode (OLED) display), and displays an output image of the smart phone 1600. The speaker 1611 converts audio signals that are outputted from the smart phone 1600 to sounds.

The wireless communication interface 1612 supports any cellular communication scheme (such as LTE and LTE-Advanced), and performs wireless communication. The wireless communication interface 1612 may typically include, for example, a base band (BB) processor 1613 and a radio frequency (RF) circuit 1614. The BB processor 1613 may perform, for example, encoding/decoding, modulating/demodulating, and multiplexing/demultiplexing, and performs various types of signal processing for wireless communication. Meanwhile, the RF circuit 1614 may include, for example, a mixer, a filter, and an amplifier, and transmits and receives wireless signals via the antenna 1616. The wireless communication interface 1612 may be a chip module having the BB processor 1613 and the RF circuit 1614 integrated thereon. As shown in Figure 16, the wireless communication interface 1612 may include multiple BB processors 1613 and multiple RF circuits 1614. Although Figure 16 shows the example in which the wireless communication interface 1612 includes the multiple BB processors 1613 and the multiple RF circuits 1614, the wireless communication interface 1612 may also include a single BB processor 1613 or a single RF circuit 1614.

Furthermore, in addition to a cellular communication scheme, the wireless communication interface 1612 may support another type of wireless communication scheme such as a short-distance wireless communication scheme, a near field communication scheme, and a wireless local area network (LAN) scheme. In this case, the wireless communication interface 1612 may include the BB processor 1613 and the RF circuit 1614 for each wireless communication scheme.

Each of the antenna switches 1615 switches connection destinations of the antennas 1616 among multiple circuits (such as circuits for different wireless communication schemes) included in the wireless communication interface 1612.

Each of the antennas 1616 includes a single or multiple antenna elements (such as multiple antenna elements included in an MIMO antenna), and is used for the wireless communication interface 1612 to transmit and receive wireless signals. As shown in Figure 16, the smart phone 1600 may include the multiple antennas 1616. Although Figure 16 shows the example in which the smart phone 1600 includes the multiple antennas 1616, the smart phone 1600 may also include a single antenna 1616.

Furthermore, the smart phone 1600 may include the antenna 1616 for each wireless communication scheme. In this case, the antenna switches 1615 may be omitted from the configuration of the smart phone 1600.

The bus 1617 connects the processor 1601, the memory 1602, the storage 1603, the external connection interface 1604, the camera 1606, the sensor 1607, the microphone 1608, the input device 1609, the display device 1610, the speaker 1611, the wireless communication interface 1612, and the auxiliary controller 1619 to each other. The battery 1618 supplies power to blocks of the smart phone 1600 shown in Figure 16 via feeder lines that are partially shown as dashed lines in the Figure 19. The auxiliary controller 1619 performs the minimal necessary function of the smart phone 1600, for example, in a sleep mode.

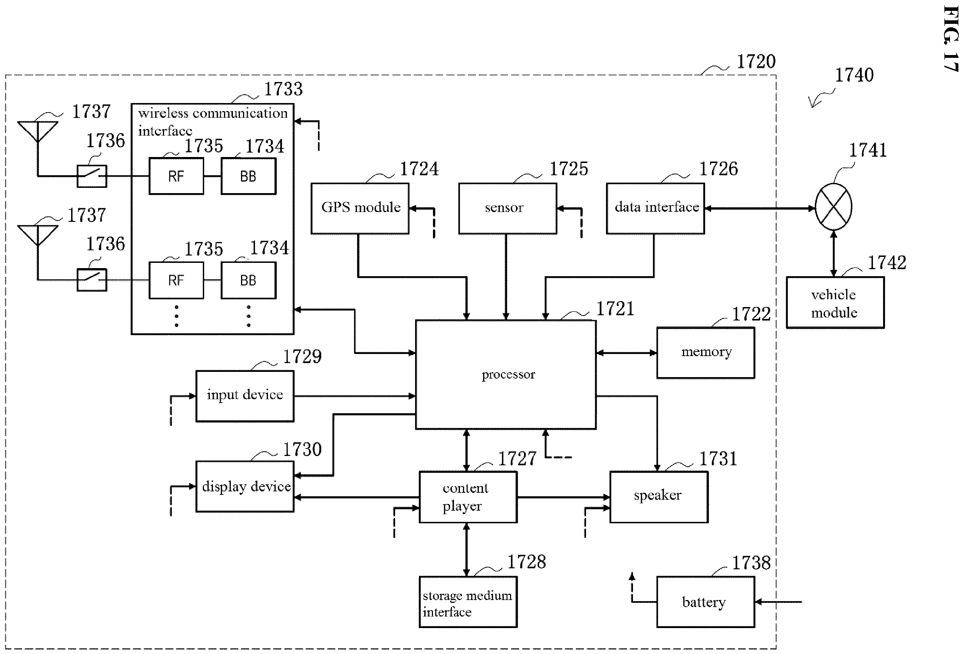

Figure 17 is a block diagram showing a schematic configuration example of a vehicle navigation device 1720 to which the technology of the present disclosure may be applied. The vehicle navigation device 1720 includes a processor 1721, a memory 1722, a global positioning system (GPS) module 1724, a sensor 1725, a data interface 1726, a content player 1727, a storage medium interface 1728, an input device 1729, a display device 1730, a speaker 1731, a wireless communication interface 1733, one or more antenna switches 1736, one or more antennas 1737, and a battery 1738.

The processor 1721 may be, for example, a CPU or a SoC, and controls a navigation function and another function of the vehicle navigation device 1720. The memory 1722 includes a RAM and a ROM, and stores a program executed by the processor 1721 and data.

The GPS module 1724 determines a position (such as latitude, longitude, and altitude) of the vehicle navigation device 1720 by using GPS signals received from a GPS satellite. The sensor 1725 may include a group of sensors such as a gyro sensor, a geomagnetic sensor, and an air pressure sensor. The data interface 1726 is connected to, for example, an onboard network 1741 via a terminal that is not shown, and acquires data (such as vehicle speed data) generated by the vehicle.

The content player 1727 reproduces content stored in a storage medium (such as a CD and a DVD) that is inserted into the storage medium interface 1728. The input device 1729 includes, for example, a touch sensor configured to detect touch onto a screen of the display device 1730, a button or a switch, and receives an operation or information inputted from a user. The display device 1730 includes a screen such as a LCD or an OLED display, and displays an image of the navigation function or content that is reproduced. The speaker 1731 outputs sounds of the navigation function or the content that is reproduced.

The wireless communication interface 1733 supports any cellular communication scheme (such as LTE and LTE-Advanced), and performs wireless communication. The wireless communication interface 1733 may typically include, for example, a BB processor 1734 and an RF circuit 1735. The BB processor 1734 may perform, for example, encoding/decoding, modulating/demodulating, and multiplexing/demultiplexing, and performs various types of signal processing for wireless communication. Meanwhile, the RF circuit 1735 may include, for example, a mixer, a filter, and an amplifier, and transmits and receives wireless signals via the antenna 1737. The wireless communication interface 1733 may also be a chip module having the BB processor 1734 and the RF circuit 1735 integrated thereon. As shown in Figure 17, the wireless communication interface 1733 may include the multiple BB processors 1734 and the multiple RF circuits 1735. Although Figure 17 shows the example in which the wireless communication interface 1733 includes the multiple BB processors 1734 and the multiple RF circuits 1735, the wireless communication interface 1733 may also include a single BB processor 1734 or a single RF circuit 1735.

Furthermore, in addition to the cellular communication scheme, the wireless communication interface 1733 may support another type of wireless communication scheme such as a short-distance wireless communication scheme, a near field communication scheme, and a wireless LAN scheme. In this case, the wireless communication interface 1733 may include the BB processor 1734 and the RF circuit 1735 for each wireless communication scheme.

Each of the antenna switches 1736 switches connection destinations of the antennas 1733 among multiple circuits (such as circuits for different wireless communication schemes) included in the wireless communication interface 1733.

Each of the antennas 1737 includes a single or multiple antenna elements (such as multiple antenna elements included in an MIMO antenna), and is used for the wireless communication interface 1733 to transmit and receive wireless signals. As shown in Figure 17, the vehicle navigation device 1720 may include the multiple antennas 1737. Although Figure 17 shows an example in which the vehicle navigation device 1720 includes the multiple antennas 1737, the vehicle navigation device 1720 may also include a single antenna 1737.

Furthermore, the vehicle navigation device 1720 may include the antenna 1737 for each wireless communication scheme. In this case, the antenna switches 1736 may be omitted from the configuration of the vehicle navigation device 1720.

The battery 1738 supplies power to blocks of the vehicle navigation device 1720 shown in Figure 17 via feeder lines that are partially shown as dashed lines in the Figure 17. The battery 1738 accumulates power supplied from the vehicle.

In the system and method according to the present disclosure, it is apparent that components or steps may be decomposed and/or recombined. The decomposing and/or recombining should be regarded as equivalent of the present disclosure. Furthermore, steps of performing the above series of processing may be naturally performed in a time order according to the order described above, but the steps are not necessarily performed in the time order. Some steps may be performed in parallel or independently from each other.

Although the embodiments of the present disclosure are described above in conjunction with the drawings, it should be understood that the embodiments described above are only used to illustrate the present disclosure rather than limit the present disclosure. For those skilled in the art, various changes and modifications may be made for the embodiments without departing from the essence and scope of the present disclosure. Therefore, the scope of the present disclosure is defined only by appended claims and equivalent meaning thereof.

## Claims

1. User equipment, comprising processing circuitry configured to:
transmit first data with first transmission power within a first period of time;
transmit differential data of the first data with second transmission power within a second period of time, wherein the differential data is a difference between second data expected to be transmitted within the second period of time and the first data.

2. The user equipment according to claim 1, wherein the first data is initial data expected to be transmitted within the first period of time.

3. The user equipment according to claim 1, wherein the processing circuitry is further configured to transmit differential indication information to indicate whether data being currently transmitted is the differential data.

4. The user equipment according to claim 1, wherein the processing circuitry is further configured to transmit power indication information to indicate current transmission power.

5. The user equipment according to claim 1, wherein the second transmission power is greater than the first transmission power.

6. The user equipment according to claim 1, wherein the processing circuitry is further configured to acquire period indication information indicating the first period of time and the second period of time.

7. The user equipment according to claim 1, wherein the processing circuitry is further configured to acquire information on calculation of the differential data and perform corresponding calculation according to the information, the information comprising one of:
not calculating the differential data;
calculating the differential data at a physical layer;
calculating the differential data at a medium access control layer; and
calculating the differential data at an application layer.

8. The user equipment according to claim 3, wherein
the differential indication information is transmitted in at least one of the following manners:
transmitting through a physical downlink control channel (PDCCH) and/or a physical uplink control channel (PUCCH) of a physical layer;
transmitting through a dedicated control channel (DCCH) of a medium access control layer; and
transmitting through control signaling of an application layer.

9. The user equipment according to claim 1, wherein the processing circuitry is further configured to acquire information on resources used for data transmission, and the resources comprise frequency domain or code domain.

10. The user equipment according to claim 1, wherein the processing circuitry is further configured to configure periods of time for data transmission and resources used for the data transmission, and the configuration is performed for each data packet.

11. The user equipment according to claim 1, wherein the second period of time is after the first period of time.

12. The user equipment according to claim 11, wherein the first period of time is followed by M consecutive second periods of time, and wherein M is an integer greater than or equal to 1.

13. The user equipment according to claim 12, wherein the configuration is performed according to the indication information, taking M periods of time as a cycle.

14. The user equipment according to claim 4, wherein the transmission power is set by the user equipment or a system comprising the user equipment.

15. The user equipment according to claim 1, wherein the processing circuitry is further configured to:
receive first control command data for the first data within the first period of time; and
receive second control command data for the second data within the second period of time.

16. The user equipment according to claim 15, wherein
the first control command data is initial control command data, and the second control command data is differential data of the first control command data or the initial control command data, wherein the differential data is a difference between the second control command data received within the second period of time and the first control command data.

17. The user equipment according to any one of claims 1 to 16, wherein the first data and the second data are data acquired by the user equipment.

18. The user equipment according to claim 17, wherein the processing circuitry is further configured to transmit the data immediately after acquisition of the data or delay the transmission a predetermined time.

19. The user equipment according to any one of claims 1 to 16, wherein the processing circuitry is further configured to transmit the first data and the second data in response to a request from another user equipment.

20. The user equipment according to claim 1, wherein the processing circuitry is further configured to configure data transmission in at least one of the following manners:
pre-configurati on;
configuration by system information; and
configuration by RRC signaling.

21. An electronic device, comprising processing circuitry configured to:
receive first data as initial data within a first period of time;
calculate first control command data based on the first data, and transmit the first control command data;
receive differential data of the first data within a second period of time, wherein the differential data is a difference between initial data expected to be received within the second period of time and the first data;
add the differential data and the first data to recover second data; and
calculate second control command data based on the second data, and transmit the second control command data.

22. The electronic device according to claim 21, wherein the processing circuitry is further configured to receive differential indication information for indicating whether data being currently received is the differential data.

23. The electronic device according to claim 22, wherein the processing circuitry is further configured to trigger the operation of recovering the second data by the differential indication information.

24. The electronic device according to claim 21, wherein the processing circuitry is further configured to receive information on calculation of the differential data and perform the corresponding recovering operation according to the information, wherein the information comprises one of:
not calculating the differential data;
calculating the differential data at a physical layer;
calculating the differential data at a medium access control layer; and
calculating the differential data at an application layer.

25. The user equipment according to claim 22, wherein the differential indication information is received in at least one of the following manners:
receiving through a physical downlink control channel (PDCCH) and/or a physical uplink control channel (PUCCH) of a physical layer;
receiving through a dedicated control channel (DCCH) of a medium access control layer; and
receiving through control signaling of an application layer.

26. The electronic device according to claim 21, further comprising:
a buffer configured to store the first data, the differential data and/or the recovered second data.

27. The electronic device according to claim 26, wherein the processing circuitry is further configured to receive indication information for indicating whether data being currently received is the differential data.

28. The electronic device according to claim 27, wherein the processing circuitry is further configured to:
trigger buffering of the first data in the buffer when the indication information indicates that the data being currently received is the first data as the initial data; and
trigger recovering of the second data based on the first data stored in the buffer and the differential data when the indication information indicates that the data being currently received is the differential data.

29. The electronic device according to claim 21, wherein the first period of time is followed by M consecutive second periods of time, and wherein M is an integer greater than or equal to 1.

30. The electronic device according to claim 21, wherein the second period of time is after the first period of time.

31. The electronic device according to claim 30, wherein the first period of time is followed by M consecutive second periods of time, and wherein M is an integer greater than or equal to 1.

32. A wireless communication method performed by user equipment, comprising:
transmitting first data with first transmission power within a first period of time; and
transmitting differential data of the first data with second transmission power within a second period of time, wherein the differential data is a difference between second data expected to be transmitted within the second period of time and the first data.

33. A wireless communication method performed by an electronic device, comprising:
receiving first data as initial data within a first period of time;
calculating first control command data based on the first data, and transmitting the first control command data;
receiving differential data of the first data within a second period of time, wherein the differential data is a difference between initial data expected to be received within the second period of time and the first data;
adding the differential data and the first data to recover second data; and
calculating second control command data based on the second data, and transmitting the second control command data.

34. A computer-readable storage medium comprising executable computer instructions that, when executed by a computer, cause the computer to implement the wireless communication method according to claim 32 or 33.
